**Europäisches Patentamt**

**European Patent Office**

**Office européen des brevets**

(19)

(11)  **EP 1 034 494 B1**

(12)  **EUROPÄISCHE PATENTSCHRIFT**

(45) Veröffentlichungstag und Bekanntmachung des Hinweises auf die Patenterteilung:
**28.11.2001 Patentblatt 2001/48**

(21) Anmeldenummer: **98951347.8**

(22) Anmeldetag: **03.09.1998**

(51) Int Cl.$^7$: **G06F 17/50**, H03B 5/02

(86) Internationale Anmeldenummer:
**PCT/EP98/05600**

(87) Internationale Veröffentlichungsnummer:
**WO 99/28839 (10.06.1999 Gazette 1999/23)**

(54) **VERFAHREN UND VORRICHTUNG ZUR RECHNERGESTÜTZTEN ERMITTLUNG EINES ANSCHWINGBEREICHS EINER ELEKTRISCHEN SCHALTUNG**

METHOD AND DEVICE FOR COMPUTER ASSISTED DETERMINATION OF AN AREA OF OSCILLATION IN AN ELECTRIC CIRCUIT

PROCEDE ET DISPOSITIF DE CALCUL ASSISTE PAR ORDINATEUR D'UNE ZONE D'AMORCE D'OSCILLATION D'UN CIRCUIT ELECTRIQUE

(84) Benannte Vertragsstaaten:
**DE FR GB**

(30) Priorität: **27.11.1997 DE 19752606**

(43) Veröffentlichungstag der Anmeldung:
**13.09.2000 Patentblatt 2000/37**

(73) Patentinhaber: **SIEMENS AKTIENGESELLSCHAFT
80333 München (DE)**

(72) Erfinder:
 • **PETER, Jürgen
 D-85604 Zorneding (DE)**
 • **NEUBERT, Rolf
 D-82008 Unterhaching (DE)**

(56) Entgegenhaltungen:
 **EP-A- 0 785 619    DE-A- 4 411 765**

 • **DURBIN F ET AL: "UNE NOUVELLE DEMARCHE POUR L'OPTIMISATION DES CIRCUITS INTEGRES: ASSOCIATION DE LA METHODE DU RECUIT SIMULE AU SIMULATEUR OUVERT SPICE-PAC" ONDE ELECTRIQUE, Bd. 70, Nr. 6, 1. November 1990, Seiten 59-65, XP000171122**

**Beschreibung**

Die Erfindung betrifft die Ermittlung eines Anschwingbereichs einer elektrischen Schaltung.

In einer integrierten digitalen Halbleiterschaltung wird gelegentlich zur Erzeugung des internen Arbeitstakts ein Oszillator verwendet. Ein Oszillator im Rahmen dieses Dokuments kann insbesondere ein Quarzoszillator oder auch ein Keramikoszillator sein.

An eine Oszillatorschaltung, die mindestens einen Oszillator aufweist, werden folgende Anforderungen gestellt:

1. Die Oszillatorschaltung soll innerhalb einer bestimmten Zeit sicher anschwingen und die Schwingung darf nicht plötzlich wieder abbrechen.
2. Die Frequenz der Oszillatorschaltung soll sich nur innerhalb eines vorgebbaren Bereichs ändern.
3. Der durch den Oszillator fließende Strom darf einen vorgebbaren Wert nicht überschreiten, um Zerstörungen oder ungewünschte Änderungen im Verhalten des Ozillators zu vermeiden.

Um diese Anforderungen zu gewährleisten ist es bekannt, in einer Oszillatorschaltung weitere Bauelemente zusätzlich zu dem Oszillator vorzusehen. Mögliche weitere Bauelemente sind beispielsweise elektrische Widerstände, elektrische Kapazitäten, elektrische Induktivitäten, Verstärkerbausteine, etc.

Die weiteren Bauelemente können nicht immer in die Halbleiterschaltung integriert werden. Ein erhebliches Problem stellt die korrekte Dimensionierung der zusätzlichen Bauelemente dar. Es gilt also, zum einen zu ermitteln, ob eine Oszillatorschaltung überhaupt anschwingen kann, und zum anderen eine Dimensionierung der weiteren Bauelemente zu ermitteln, mit der ein sicheres Anschwingen gewährleistet wird.

Es ist bekannt, dieses Problem ausschließlich auf meßtechnischem Wege zu lösen. Dazu wird eine integrierte Schaltung mit dem Oszillator und den erforderlichen weiteren Bauelementen aufgebaut. Die Schaltung wird daraufhin meßtechnisch überprüft, ob sie das gewünschte Verhalten bezüglich Anschwingsicherheit, Frequenzkonstanz und maximaler Strombelastung des Oszillators erfüllt.

Um eine günstige Dimensionierung der weiteren Bauelemente zu ermitteln, müssen die Schaltungen jeweils mit den unterschiedlichen Bauelementewerten aufgebaut und die Messungen jeweils überprüft werden. Die Bauelementewerte und die Information, ob die Schaltung mit den jeweiligen Dimensionierungen der weiteren Bauelemente anschwingt oder nicht, werden bei dem bekannten Verfahren in einer Matrix festgehalten, aus der die günstigsten Dimensionierungen für die weiteren Bauelemente ermittelt werden.

Diese Vorgehensweise birgt erhebliche Nachteile in sich:

1. Das bekannte Verfahren ist zeitaufwendig, da der Austausch der zu variierenden Bauelemente und die entsprechenden Messungen nicht automatisierbar sind.
2. Die Meßergebnisse sind ungenau, da Fertigungstoleranzen bei der Herstellung der integrierten Schaltungen oder beim Oszillator nicht berücksichtigt werden können. Somit ist eine Berücksichtigung der Ergebnisse hinsichtlich der unterschiedlichen Qualität der Bauelemente nicht möglich.
3. Es ist nur unter sehr aufwendigen und kostenintensiven Bemühungen überhaupt möglich, unterschiedliche Betriebsbedingungen wie beispielsweise sehr hohe oder sehr niedrige Temperatur, unter der die elektrische Schaltung arbeiten muß, herzustellen.

Dies führt zu einer sehr ungenauen und aufwendigen Ermittlung der Bauelementewerte und nur zu unzuverlässigen Aussagen hinsichtlich der Anschwingsicherheit für eine vorgegebene Dimensionierung der weiteren Bauelemente.

Aus [1] ist ein Verfahren zur Stabilitätsanalyse einer elektrischen Schaltung bekannt.

In [2], [3], [4] sind Verfahren zur Bestimmung eines Hopf-Bifurkations-Punktes beschrieben. Ein Hopf-Bifurkations-Punkt ist ein Punkt auf einer DC-Kennlinie, an dem eine Änderung der untersuchten elektrischen Schaltung hinsichtlich ihres Stabilitätsverhaltens stattfindet, d.h. der Punkt, an dem die Schaltung von einem stabilen stationären Zustand in einen schwingenden Zustand wechselt.

Aus [5] ist ein Verfahren zur rechnergestützten iterativen Bestimmung des Einschwingverhaltens einer Quarzoszillatorschaltung bekannt. Dabei wird auf eine die Quarzoszillatorschaltung substituierende Stromquelle für einen ermittelten, vorgebbaren Arbeitspunkt abwechselnd ein dynamischer Gleichgewichtszustand ermittelt und eine Transientenanalyse durchgeführt. Die Transientenanalyse erfolgt für die Schaltung mit rücksubstituierter Quarzoszillatorschaltung.

Weiterhin ist es aus [6] bekannt, ausgehend von einer qualitativ hochwertigen Startlösung eine periodische Zustandsbeschreibung des technischen Systems zu ermitteln.

Ferner sind sog. Verfolgungsverfahren aus [4] bekannt, mit denen aus einer periodischen Zustandsbeschreibung weitere periodische Lösungen zur Beschreibung der Schaltung ermittelt werden können, um somit eine periodische Lösung der Schaltung in einem vorgebbaren Arbeitspunkt zu ermitteln. Die Verfolgungsverfahren werden auch als Prädiktor-Korrektor-Verfahren bezeichnet.

Aus [8] ist ein Verfahren zum Entwurf von Oszillatoren mit minimiertem Rauschen bekannt. Bei diesem Verfahren wird ein lineares Teilnetzwerk, welches z.B. geometrische Daten des Layouts, Werte von passiven elektronischen Bauteilen (Kondensatoren, Induktivitäten, Widerstände) oder Parameter eines aktiven Elements des Oszillators (z.B. Parameter des Transistors) enthält, derart berechnet, daß das Phasenrauschen minimal wird. Dazu wird das Signal- und Räuschverhalten des Oszillators durch Diffentialgleichungen beschrieben. Unter der Nebenbedingung, daß die Diffentialgleichungen für das Signalverhalten erfüllt werden, wird ein Einseitenbandphasenrauschen des Oszillators mit direkten Methoden der optimalen Steuerung optimiert.

Der Erfindung liegt das Problem zugrunde, rechnergestützt einen Anschwingbereich einer elektrischen Schaltung, die mindestens einen Quarzoszillator und weitere Bauelemente aufweist, die mit dem Quarzoszillator verbunden sind, anzugeben, wobei die oben beschriebenen Nachteile des Standes der Technik vermieden werden.

Das Problem wird durch das Verfahren gemäß Patentanspruch 1 sowie durch die Vorrichtung gemäß Patentanspruch 6 gelöst.

Bei dem Verfahren werden iterativ unter Variation von Beschaltungsparametern der weiteren Bauelemente jeweils für eine Instanz der Beschaltungsparameter folgende Schritte durchgeführt:

- es wird für die jeweilige Instanz eine Stabilitätsanalyse der Schaltung durchgeführt,
- wird für die Instanz ermittelt, daß sie anschwingt, so wird der Instanz in einer Matrix ein erster Wert zugeordnet, wobei mit dem ersten Wert angegeben wird, daß die Instanz der Schaltung anschwingt. In der Matrix sind alle untersuchten Instanzen gespeichert. Wird für die Instanz der Schaltung ermittelt, daß die Instanz nicht anschwingt, so wird der Instanz in der Matrix ein zweiter Wert zugeordnet, wobei mit dem zweiten Wert angegeben wird, daß die Instanz nicht anschwingt,
- der Anschwingbereich ergibt sich aus den Instanzen, denen der erste Wert in der Matrix zugeordnet wurde.

Die Vorrichtung weist eine Prozessoreinheit auf, die derart eingerichtet ist, daß iterativ unter Variation von Beschaltungsparametern der weiteren Bauelemente jeweils für eine Instanz der Beschaltungsparameter folgende Schritte durchgeführt werden. Es wird für die jeweilige Instanz eine Stabilitätsanalyse der Schaltung durchgeführt. Wird für die Instanz der Schaltung ermittelt, daß die Instanz der Schaltung anschwingt, so wird der Instanz in einer Matrix ein erster Wert zugeordnet, wobei mit dem ersten Wert angegeben wird, daß die Instanz anschwingt. In der Matrix sind alle untersuchten Instanzen gespeichert. Wird für die Instanz der Schaltung ermittelt, daß sie nicht anschwingt, so wird der Instanz in der Matrix ein zweiter Wert zugeordnet, wobei mit dem zweiten Wert angegeben wird, daß die Instanz der Schaltung nicht anschwingt. Der Anschwingbereich ergibt sich aus den Instanzen, denen der erste Wert in der Matrix zugeordnet wurde.

Unter einer Instanz ist jeweils die Oszillatorschaltung mit bestimmten Dimensionierungen der weiteren Bauelemente und/oder bestimmten Temperaturbedingungen, Betriebsbedingungen und/oder bestimmten Toleranzen der weiteren Bauelemente zu verstehen.

Durch die Erfindung wird erstmals eine sehr einfache, automatisierte Ermittlung eines Anschwingbereichs für eine Oszillatorschaltung angegeben. Es ist mit der Erfindung ferner möglich, Bauelemente unterschiedlicher Qualität mit verschiedenen Toleranzwerten zu berücksichtigen. Auch extreme Betriebsbedingungen können im Rahmen der Schaltungssimulation gemäß der Erfindung berücksichtigt werden.

Vorteilhafte Weiterbildungen der Erfindung ergeben sich aus den abhängigen Ansprüchen.

Der Oszillator kann ein Quarzoszillator oder ein Keramikoszillator sein.

Die weiteren Bauelemente können elektrische Widerstände, Kapazitäten, Induktivitäten, Verstärkerbauelemente, etc. sein.

Die Stabilitätsanalyse der elektrischen Schaltung kann nach unterschiedlichen Verfahren erfolgen. Es hat sich als vorteilhaft herausgestellt, die Stabilitätsanalyse unter Ermittlung eines Hopf-Bifurkations-Punktes für die jeweilige Instanz durchzuführen. Dies ist ein äußerst einfacher und somit Rechenzeit einsparender Weg zur Stabilitätsanalyse.

Weitere Möglichkeiten zur Stabilitätsanalyse sind (während einer DC-Transfer-Analyse simultan):

• eine Pol-Nullstellen-Analyse,
• eine AC-Analyse (Kleinsignal-Analyse) unter Verwendung des Bode-Kriteriums oder des Nyquist-Kriteriums,
• eine Transientenanalyse.

Für einen Teil der Instanzen kann eine Berechnung des Schwingungszustandes oder dynamischen Gleichgewichts der Instanz in einem vorgebbaren Arbeitspunkt nach einem der in [2], [3], [4] beschriebenen Verfahren erfolgen. Durch diese Weiterbildung wird für die Instanz auch noch untersucht, ob die Schaltung in dem vorgegebenen Arbeitspunkt weiterschwingt. Somit kann für die jeweilige Instanz auch das sichere Weiterschwingen der Schaltung gewährleistet werden.

In einer weiteren Ausgestaltung der Erfindung ist es vorgesehen, daß für mindestens einen Teil der Instanzen eine Bestimmung des jeweiligen Einschwingverhaltens durchgeführt wird. Dies hat den Vorteil, daß nach erfolgter Bestimmung des Einschwingverhaltens alle interessanten Informationen für die Instanz mit der jeweiligen Dimensionierung bekannt sind. Somit sind alle gewünschten Informationen über die Schaltung verfügbar.

Ein Ausführungsbeispiel der Erfindung ist in den Figuren dargstellt und wird im weiteren näher erläutert.

Es zeigen

Figur 1     eine 2-dimensionale Matrix, in der für verschiedene Dimensionierungen zweier Kapazitäten der Anschwingbereich einer elektrischen Schaltung dargestellt ist;
Figur 2     eine Skizze einer elektrischen Schaltung, für die die Matrix in Fig. 1 ermittelt wurde;
Figur 3     ein Bifurkationsdiagramm einer Oszillatorschaltung.

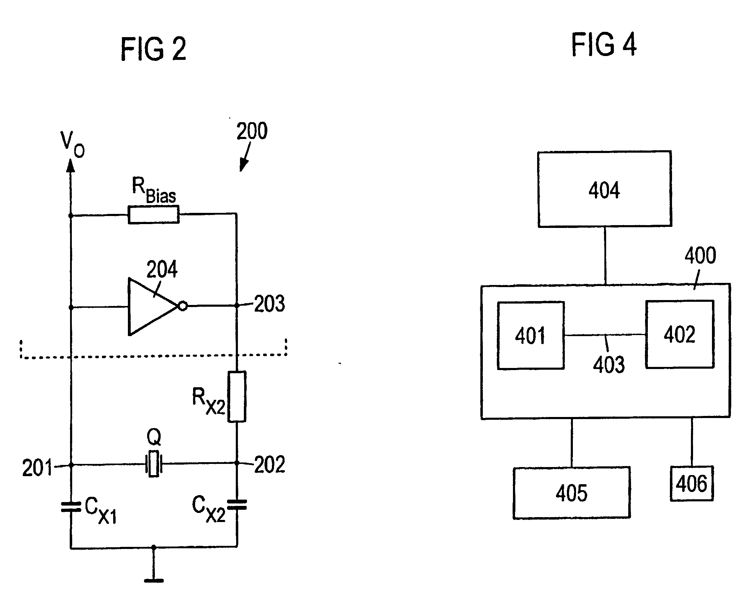

In Fig. 2 ist ein Oszillator Q gezeigt, der mit einem ersten Anschluß 201 zum einen mit einer Versorgungsspannung $V_0$ und zum anderen mit einer ersten Kapazität $C_{X1}$ verbunden ist. Die erste Kapazität $C_{X1}$ ist ferner mit Masse und mit einer zweiten Kapazität $C_{X2}$ verbunden. Die zweite Kapazität $C_{X2}$ ist über einen zweiten Anschluß 202 mit dem Oszillator Q und einem elektrischen Widerstand $R_{X2}$ verbunden. Der zweite Widerstand $R_{X2}$ ist über einen dritten Anschluß 203 mit einem Ausgang eines Inverters 204 und eines Vorschaltwiderstands $R_{Bias}$ verbunden, die beide ihrerseits mit der Versorgungsspannung über den ersten Anschluß 201 verbunden sind.

Es ist für die Oszillatorschaltung 200 der Anschwingbereich mit den zugehörigen Dimensionierungen (Instanzen) der weiteren Bauelemente (erste Kapazität $C_{X1}$, zweite Kapazität $C_{X2}$ und elektrischer Widerstand $R_{X2}$) zu ermitteln.

Zur Ermittlung des Anschwingbereichs der Oszillatorschaltung 200 wird folgendes iterative Verfahren für unterschiedliche Instanzen der Oszillatorschaltung 200 durchgeführt.

Es wird in jedem Iterationsschritt eine Instanz, d.h. eine Dimensionierung bzw. eine Festlegung der weiteren Bauelemente sowie der Rahmenbedingungen (Betriebsbedingungen Toleranzen der Bauelemente) vorgegeben.

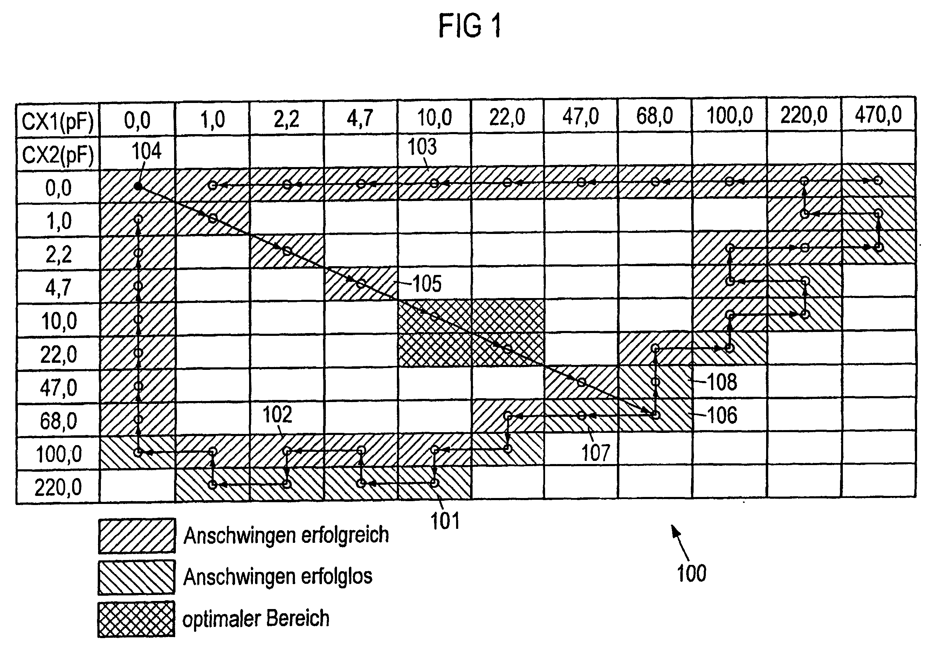

In diesem Ausführungsbeispiel wird zur einfacheren Darstellung das Verfahren anhand eines vorgegebenen elektrischen Widerstands $R_{X2}$ und vorgegebenen Randbedingungen aufgezeigt, d.h. es werden die erste Kapazität $C_{X1}$ und die zweite Kapazität $C_{X2}$ jeweils in einem vorgebbaren Dimensionierungsintervall variiert, was jeweils in einer Spalte einer in Figur 1 dargestellten Tabelle für die zweite Kapazität $C_{X2}$ in Pikofarad (pF) und in einer ersten Zeile für die erste Kapazität $C_{X1}$ in pF dargestellt ist. Für jede Instanz wird eine Stabilitätsanalyse der Oszillatorschaltung 200 durchgeführt.

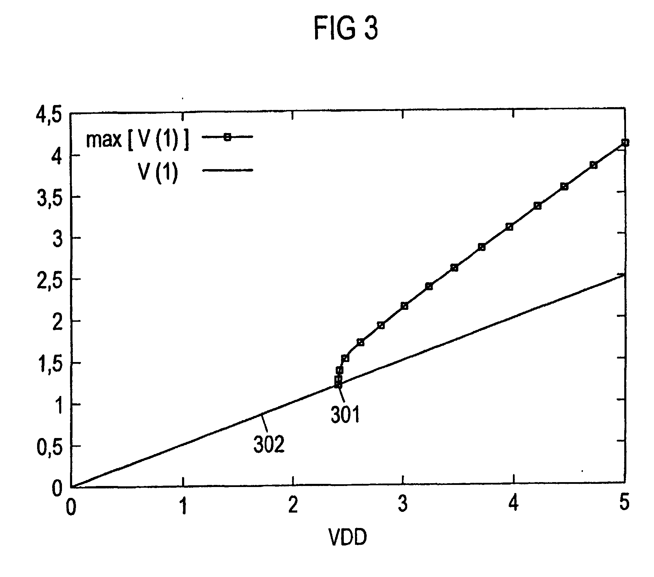

Dies erfolgt durch Ermittlung des Hopf-Bifurkations-Punkts 301 (vgl. Fig. 3). Ein Hopf-Bifurkations-Punkt 301 ist ein Punkt einer elektrischen Schaltung, an dem die elektrischen Schaltungen von einem stabilen in einen instabilen, d.h. schwingenden Zustand übergeht.

Die Ermittlung des Hopf-Bifurkations-Punkts 301 erfolgt gemäß einem der in [2], [3], oder [4] beschrieben Verfahren.

Ferner wird für einen vorgebbaren Arbeitspunkt gemäß dem im weiteren beschriebenen Verfahren überprüft, ob die elektrische Schaltung auch in dem Arbeitspunkt der Schaltung stabil schwingt.

Der Hopf-Bifurkationspunkt HP wird durch ein Tripel beschrieben, welches einen Eigenwert $\mu_0$, dessen Imaginärteil auch als Eigenfrequenz der Schaltung bezeichnet wird, eine Ruhelage $y_0$ des Hopf-Bifurkationspunktes HP sowie einen Eigenvektor $v_0$ aufweist.

Der Hopf-Bifurkationspunkt HP ist also z.B. durch folgendes Tripel gegeben:

$$HP = (\mu_0, y_0, v_0) := (\mu(\lambda_0), y(\lambda_0), v(\lambda_0)) \tag{1}.$$

Mit $\lambda_0$ wird jeweils der Systemparameter $\lambda$ bezeichnet, für den man für die Schaltung den Hopf-Bifurkationspunkt HP erhält.

**Ermittlung der Bifurkationsebenen $\pi_\lambda$ für den jeweiligen Systemparameter $\lambda$ 102**

Ausgehend von dem Hopf-Bifurkationspunkt HP werden in einem weiteren Schritt Bifurkationsebenen $\pi_\lambda$ ermittelt.

Hierzu wird jeweils für den Systemparameter $\lambda$ und der entsprechenden Lösung $y(\lambda)$ in einer Umgebung des Hopf-Bifurkationspunktes HP mit dem entsprechenden Systemparameter $\lambda_0$ der Eigenwert $\mu(\lambda)$ und der Eigenvektor $v(\lambda)$ ermittelt. Für den speziellen Systemparameter $\lambda_0$ ergibt sich der Hopf-Bifurkationspunkt HP.

Eine Möglichkeit, die Bifurkationsebenen $\pi_\lambda$ zu bilden, besteht darin, die Eigenvektoren $v(\lambda)$ zu verwenden, um im komplexen Raum C durch die Realteile Re$\{v(\lambda)\}$ bzw. die Imaginärteile Im$\{v(X)\}$ der Eigenvektoren $v(\lambda)$ die Bifurkationsebenen $\pi_\lambda$ aufzuspannen.

Eine Bifurkationsebene $\pi_\lambda$ ergibt sich nach folgender Vorschrift:

$$\pi\lambda = \{z | z = c \cdot v(\lambda), c \in C\} \qquad (2).$$

Die Bifurkationsebenenschar $\Pi$ ergibt sich nach folgender Vorschrift:

$$\Pi = \{ \pi_\lambda \mid \lambda \in \mathfrak{R} \}.$$

Dabei ist ein Faktor c eine beliebige komplexe Zahl. Bei Verwendung von reellen Zahlen $\mathfrak{R}$ ist die Bifurkationsebene $\pi_\lambda$ zweidimensional, bei Verwendung komplexer Zahlen C ist die Bifurkationsebene $\pi_\lambda$ eindimensional.

Durch Verwendung der Bifurkationsebene $\pi_\lambda$ und somit einer Transformation des gesamten möglichen Zustandsraums, bei einem komplexen technischen System, welches durch eine höhere Anzahl von differential algebraischen Gleichungen beschrieben wird, aus einem sehr hochdimensionalen Zustandsraum zur Ermittlung der periodischen Zustandsbeschreibung auf einen niederdimensionalen Raum einer Ebene, der Bifurkationsebene $\pi_\lambda$, wird die Ermittlung der periodische Zustandsbeschreibung möglich.

**Ermittlung der periodischen Zustandsbeschreibung**

Im weiteren wird eine frei vorgebbare Kurve gewählt, die sich jedoch in der Bifurkationsebenenschar $\Pi$ befindet.

Allgemein kann für jeden Punkt entlang der Kurve eine periodische Zustandsbeschreibung durch folgende Funktion beschrieben werden:

$$x(t) = c_p v(\lambda) e^{i\omega(\lambda)t} + \overline{c_p v(\lambda)} e^{-i\omega(\lambda)t} + y(\lambda) \qquad (3).$$

Dabei gilt:

$$\omega(\lambda) = \operatorname{Im}(\mu(\lambda)).$$

Der Faktor cp wird derart gewählt, daß $c_p v(\lambda)$ den Punkt P ergibt.

Dieser allgemeine Ansatz zur Beschreibung eines periodischen Zustandes aus der Gleichung (3) ist im allgemeinen keine Lösung des differential algebraischen Systems.

Dies bedeutet, daß folgender Zusammenhang gilt:

$$f(x(t), x(t), \lambda) \neq 0 \qquad (4).$$

Um innerhalb der Bifurkationsebenenschar $\Pi$, entlang der Kurve eine Lösung und somit eine periodische Zustandsbeschreibung zu ermitteln, ist es erforderlich, daß die Vorschrift (3) zu einer Lösung des differential algebraischen Gleichungssystems führt.

Dies kann in einer Weise gelöst werden, daß ein zusätzlicher Strafterm F(t) berücksichtigt wird, der folgende Struktur aufweist:

$$F(t) = -f(x(t), \dot{x}(t), \lambda) \qquad (5).$$

Es ergibt sich folgende Leistungsfunktion P(t):

$$P(t) = x(t)^T \cdot f(x(t), \dot{x}(t), \lambda) \qquad (6).$$

Mit t wird jeweils die Zeit, zu dem das technische System beschrieben wird, bezeichnet. Anschaulich kann x als eine Strömungsgeschwindigkeit eines mechanischen dynamischen Systems betrachtet werden.

Aus der Leistungsfunktion P(t) kann eine Energiefunktion E(t) ermittelt werden durch Integration der Leistungsfunktion P(t) über eine Periode der jeweiligen Schwingung:

$$E(\lambda) = \int x(t)^T \cdot f(x(t), \dot{x}(t), \lambda) dt \qquad (7).$$

Für eine periodische Lösung eines differential algebraischen Gleichungssystems ist die Energiefunktion E(t) total balanciert, da für diese folgende Vorschrift gilt:

$$f(x(t), \dot{x}(t), \lambda) = 0 \qquad (8).$$

Dies gilt für alle Zeitpunkte t.

Mit anderen Worten bedeutet dies, daß eine balancierte Energiefunktion E(t) eine Eigenschaft einer periodischen Lösung einer Schaltung ist. Diese Eigenschaft kann im weiteren dazu verwendet werden, einen Punkt zu ermitteln, mit dem es möglich ist, eine gute periodische Zustandsbeschreibung der Schaltung abzuschätzen.

Der Punkt wird dadurch ermittelt, daß entlang der Kurve in frei vorgebbaren Intervallschritten jeweils die Energiefunktion E(λ) für einen Punkt der Kurve ermittelt wird. Da gezeigt werden kann, daß eine Nullstelle des Realteils der Energiefunktion Re{E(λ) } an dem jeweiligen ausgewerteten Punkt auf der Kurve einen sehr guten Punkt ergibt, mit dem eine sehr gute periodische Zustandsbeschreibung der Schaltung ermittelt werden kann, wird eine Nullstelle des Realteils der Energiefunktion Re{E(λ) } des technischen Systems ermittelt.

Zur Ermittlung der Nullstelle des Realteils der Energiefunktion Re{E(λ) } kann ein beliebiges Verfahren zur eindimensionalen Nullstellen-Analyse, die auch als ableitungsfreie Nullstellen-Verfahren bezeichnet werden, eingesetzt werden.

Es ist vorteilhaft, daß die Kurve eine halboffene, kreisförmige Kurve um den Hopf-Bifurkationspunkt ist.

Als Anhaltspunkt für die Größe der Kurve abhängig von dem Hopf-Bifurkationspunkt und dem Eigenwert $\mu_0$ des Hopf-Bifurkationspunktes wird folgender Dimensionierungsvorschlag gegeben, der sich als vorteilhaft herausgestellt hat.

Eine Ellipse um den Hopf-Bifurkationspunkt, auch als halboffene Kurve, deren Sekante entlang der ersten Lösungskurve der stationären Lösungen ungefähr max. 2% des zu untersuchenden Parameterbereichs, in dem der Systemparameter λ variiert wird, symmetrisch um den Hopf-Bifurkationspunkt, hat sich als vorteilhaft erwiesen. Als Höhe der Ellipse ist ein Wert zwischen 0,1 und 1 Volt geeignet.

Für die Nullstelle, also für den ermittelten Punkt auf der Kurve wird die zu dem Punkt gehörende periodische Zustandsbeschreibung x(t) ermittelt.

Für die periodische Zustandsbeschreibung x(t) wird eine periodische Lösung der Schaltung ermittelt, z.B. mittels der in dem Dokument [6] beschriebenen Vorgehensweise.

Die periodische Zustandsbeschreibung x(t) der Schaltung ist die periodische Lösung der Schaltung für den Systemparameter λ.

Die periodische Zustandsbeschreibung wird als Startlösung für die Ermittlung weiterer periodischer Lösungen, ausgehend von der Startlösung, also der periodischen Zustandsbeschreibung, verwendet.

Da mit der Startlösung eine sehr gute Näherung für eine Lösung auf der zweiten Lösungskurve in der Nähe des Hopf-Bifurkationspunktes ermittelt wurde, ist es nunmehr möglich, durch Verwendung von den in [7] beschriebenen Verfolgungsverfahren, weitere periodische Lösungen der Schaltung, die sich auf der zweiten Lösungskurve befinden, zu ermitteln.

Dies wird iterativ solange weitergeführt, bis eine periodische Lösung zu einem vorgebbaren Arbeitspunkt der Schaltung ermittelt wurde.

Als Verfahren zur Ermittlung der periodischen Lösung für einen Systemparameter $\lambda$ kann beispielsweise das Verfahren der harmonischen Balance eingesetzt werden.

Das Ergebnis einer Iteration ist also jeweils, ob die Instanz der Oszillatorschaltung 200 anschwingt oder nicht.

Schwingt die Instanz der Schaltung an, so wird in der Matrix 100 jeweils in dem Feld, das eindeutig durch die Dimensionierungen der Kapazitäten $C_{X1}$, $C_{X2}$ bestimmt ist, ein zweiter binärer Wert 101 eingefügt. Schwingt die Instanz jedoch an, so wird ein erster binärer Wert 102 dem entsprechenden Feld in der Matrix 100 zugeordnet.

Aus dem sich ergebenden Anschwingbereich 103, der durch die jeweiligen Instanzen, die anschwingen, begrenzt ist, wird eine Menge von Instanzen ausgewählt, für die das gesamte Einschwingverhalten der Quarzoszillatorschaltung ermittelt wird.

Ein Verfahren zur Ermittlung des Einschwingverhaltens eines Quarzoszillators erfolgt gemäß dem Verfahren, das in [3] beschrieben ist.

Im weiteren werden einige Alternativen für das oben beschriebene Ausführungsbeispiel aufgezeigt.

Es ist nicht erforderlich, alle Instanzen der Oszillatorschaltung 200 zu untersuchen. Ausgehend von einem Startpunkt 104 werden Instanzen, anschaulich gesprochen, in einer Diagonale der 2-dimensionalen Matrix 100, bei einer höherdimensionalen Matrix entsprechend einer Raum-Diagonale des durch die höherdimensionale Matrix beschriebenen Hyperraums, die Instanzen der Stabilitätsanalyse unterzogen. In Figur 1 ist diese Vorgehensweise durch einen Pfeil 105 in der Matrix 100 dargestellt. Die Diagonale wird solange weiterverfolgt, bis eine Instanz der Schaltung nicht anschwingt. Diese Instanz ist in der Matrix 100 mit dem Bezugszeichen 106 bezeichnet.

Ausgehend von der ersten Instanz, die nicht anschwingt, wird in einem treppenförmigen Vorgehen, dessen Weg jeweils durch einen Pfeil 107 bzw. 108 in der Matrix 100 dargestellt ist, entlang des Randbereichs stabiler und instabiler Instanzen durchgeführt.

Dieses Vorgehen entspricht einer Abtastung des Randbereichs, wodurch eine Überprüfung eines großen Teilbereichs in der gesamten Matrix 100 nicht erforderlich ist.

Wie oben beschrieben, ist die Dimensionalität der Matrix 100 beliebig. Entsprechend sind auch die weiteren Bauelemente grundsätzlich beliebig und, wie oben beschrieben, können verschiedenste Parameter in der Schaltungssimulation berücksichtigt werden.

Generell ist zu dem Anschwingbereich 103 zu bemerken, daß je näher der Wert des ermittelten Hopf-Bifurkations-Punkts 301 für die Instanz an der Versorgungsspannung $V_0$ ist, umso kritischer ist ein sicheres Anschwingen der Oszillatorschaltung 200.

Fig. 4 zeigt einen Rechner 400, mit dem das Verfahren durchgeführt wird. Der Rechner 400 weist einen Speicher 401, eine Prozessoreinheit 402, die über einen Bus 403 mit dem Speicher 401 verbunden ist auf. In dem Speicher 401 ist eine Beschreibung der Oszillatorschaltung 200 in einer Schaltungsbeschreibungssprache, z.B. SPICE gespeichert. Die Prozessoreinheit 402 ist derart eingerichtet, daß die oben beschriebenen Verfahrensschritte zur Schaltungssimulation durchführbar sind. Ferner ist ein Bildschirm 404 vorgesehen zur Darstellung der Ergebnisse sowie eine Tastatur 405 und eine Maus 406 zur Eingabe von Information in den Rechner 400.

In diesem Dokument sind folgende Veröffentlichungen zitiert:

[1] L. O. Chua, C. A. Desor, E. S. Kuh, Linear and Nonlinear Circuits, Mc Graw Hill, ISBN 0-07-010898-6, New York, S. 644 - 687, 1987

[2] R. Neubert, An Effective Method for the Stability Analyses of Steady States in the Simulation of Large Electrical Networks, 2. ITG-Diskussionssitzung, Neue Anwendungen theoretischer Konzepte in der Elektrotechnik, W. Mathis, P. Noll (ed.), VDE-Verlag, Berlin, ISBN 3-8007-2190-2, April 1995, S. 41-48

[3] Qinghua Zheg, Hopf Bifurcation in Diffential Algebraic Equations and Applications to Circuit Simulation, Internat. Series of Numerical Mathematics, Vol. 93, Birkhäuser Verlag Basel, ISBN 0-9176-2439-2, S. 45-58, 1989

[4] R. Neubert, Predictor-Corrector Techniques for Detecting Hopf Bifurcation Point, Internat. Journal of Bifurcation and Chaos, Vol. 3, Nr. 5, ISSN 0218-1274, World Scientific Company, S. 1311-1318, 1993

[5] EP 0 785 619 A2

[6] U. Feldmann et al, Algorithms for Modern Circuit Simulation AEÜ, Vol. 46, Nr. 4, ISSN 0001-1096, Hirzel-Verlag, Stuttgart, S. 274-285, 1992

[7] R. Seydel, Numerical Computation of Periodic Orbits that Bifurcate from Stationary Solutions of Ordinary Differential Equations, Technische Universität München, Institut für Mathematik, TUM-MATH-12-81-M12-250/1-FMA, S. 1-43, 1981

[8] DE 44 11 765 A1

**EP 1 034 494 B1**

**Patentansprüche**

1. Verfahren zur rechnergestützten Ermittlung eines Anschwingbereichs einer elektrischen Schaltung, die mindestens einen Oszillator und weitere Baulemente aufweist, die mit dem Oszillator verbunden sind, bei dem in einem iterativen Verfahren unter Variation von Beschaltungsparametern der weiteren Baulemente jeweils für eine Parameterkombination der Beschaltungsparameter folgende Schritte durchgeführt werden:

   - es wird für die jeweilige Parameterkombination eine Stabilitätsanalyse der Schaltung durchgeführt,
   - wird für die Parameterkombination der Schaltung ermittelt, daß die Parameterkombination anschwingt, so wird der Parameterkombination in einer Matrix, in der alle untersuchten Parameterkombinationen gespeichert sind, ein erster Wert zugeordnet, wobei mit dem ersten Wert angegeben wird, daß die Parameterkombination anschwingt,
   - wird für die Parameterkombination der Schaltung ermittelt, daß die Parameterkombination nicht anschwingt, so wird der Parameterkombination in der Matrix ein zweiter Wert zugeordnet, wobei mit dem zweiten Wert angegeben wird, daß die Parameterkombination nicht anschwingt,
   - bei dem sich der Anschwingbereich ergibt aus den Parameterkombination denen der erste Wert in der Matrix zugeordnet wurde.

2. Verfahren nach Anspruch 1,
   bei dem die Stabilitätsanalyse nach einem der folgenden Verfahren durchgeführt wird:

   - Ermittlung eines Hopf-Bifurkationspunkts für die jeweilige Instanz,
   - Pol-Nullstellen-Analyse,
   - AC-Analyse (Kleinsignal-Analyse) unter Verwendung des Bode-Kriteriums oder des Nyquist-Kriteriums,
   - Transientenanalyse.

3. Verfahren nach Anspruch 1 oder 2,
   bei dem die Beschaltungsparameter der weiteren Baulemente mindestens einen der folgende Parameter aufweisen:

   - unterschiedliche Temperaturen, denen die Schaltung ausgesetzt ist,
   - unterschiedliche Qualität der weiteren Bauelemente,
   - unterschiedliche Dimensionierungswerte der weiteren Baulemente.

4. Verfahren nach einem der Ansprüche 1 bis 3,
   bei dem mindestens für einen Teil der Parameterkombinationen eine Stabilitätsanalyse im Arbeitspunkt durchgeführt wird.

5. Verfahren nach Anspruch 4,
   bei dem mindestens für einen Teil der Parameterkombinationen eine Bestimmung des Einschwingverhaltens der Instanz Parameterkombination durchgeführt wird.

6. Vorrichtung zur rechnergestützten Ermittlung eines Anschwingbereichs einer elektrischen Schaltung, die mindestens einen Oszillator und weitere Baulemente aufweist, die mit dem Oszillator verbunden sind,
   mit einer Prozessoreinheit, die derart eingerichtet ist, daß in einem iterativen Verfahren unter Variation von Beschaltungsparametern der weiteren Baulemente jeweils für eine Parameterkombination der Beschaltungsparameter folgende Schritte durchgeführt werden:

   - es wird für die jeweilige Parameterkombination eine Stabilitätsanalyse der Schaltung durchgeführt.
   - wird für die Parameterkombination der Schaltung, ermittelt, daß die Parameterkombination anschwingt, so wird der Parameterkombination in einer Matrix, in der alle untersuchten Parameterkombinationen gespeichert sind, ein erster Wert zugeordnet, wobei mit dem ersten Wert angegeben wird, daß die Parameterkombination anschwingt,
   - wird für die Parameterkombination der Schaltung ermittelt, daß die Parameterkombination nicht anschwingt, so wird der Parameterkombination in der Matrix ein zweiter Wert zugeordnet, wobei mit dem zweiten Wert angegeben wird, daß die Parameterkombination nicht anschwingt,
   - der Anschwingbereich ergibt sich aus den Parameterkombinationen, denen der erste Wert in der Matrix zugeordnet wurde.

8

**7.** Vorrichtung nach Anspruch 6,
bei der die Prozessoreinheit derart eingerichtet ist, daß die Stabilitätsanalyse nach einem der folgenden Verfahren durchgeführt wird:

- Ermittlung eines Hopf-Bifurkationspunkts für die jeweilige Instanz,
- Pol-Nullstellen-Analyse,
- AC-Analyse (Kleinsignal-Analyse) unter Verwendung des Bode-Kriteriums oder des Nyquist-Kriteriums,
- Transientenanalyse.

**8.** Vorrichtung nach Anspruch 6 oder 7,
bei der die Prozessoreinheit derart eingerichtet ist, daß die Beschaltungsparameter der weiteren Baulemente mindestens einen der folgende Parameter aufweisen:

- unterschiedliche Temperaturen, denen die Schaltung ausgesetzt ist,
- unterschiedliche Qualität der weiteren Bauelemente,
- unterschiedliche Dimensionierungswerte der weiteren Baulemente.

**9.** Vorrichtung nach einem der Ansprüche 6 bis 8,
bei der die Prozessoreinheit derart eingerichtet ist, daß mindestens für einen Teil der Parameterkombinationen eine Stabilitätsanalyse im Arbeitspunkt durchgeführt wird.

**10.** Vorrichtung nach Anspruch 9,
bei der die Prozessoreinheit derart eingerichtet ist, daß mindestens für einen Teil der Parameterkombinationen eine Bestimmung des Einschwingverhaltens der Parameterkombination durchgeführt wird.


**Claims**

**1.** Method for computer-aided determination of an oscillation-inception band of an electrical circuit which has at least one oscillator and further components which are connected to the oscillator,
in which the following steps are in each case carried out for a parameter combination of the circuitry parameters using an iterative method and varying circuitry parameters of the further components:

- a stability analysis of the circuit is carried out for the respective parameter combination,
- if it is found for the parameter combination of the circuit that the parameter combination starts to oscillate, then that parameter combination is allocated a first value in a matrix in which all the investigated parameter combinations are stored, with the first value indicating that the parameter combination starts to oscillate,
- if it is found for the parameter combination of the circuit that the parameter combination does not start to oscillate, then that parameter combination is allocated a second value in the matrix, with the second value indicating that the parameter combination does not start to oscillate,
- in which the oscillation-inception band is obtained from the parameter combinations to which the first value in the matrix was allocated.

**2.** Method according to Claim 1,
in which the stability analysis is carried out using one of the following methods:

- determination of a hop bifurcation point for the respective entity,
- pole zero-point analysis,
- AC analysis (small signal analysis) using the Bode criterion or the Nyquist criterion,
- transient analysis.

**3.** Method according to Claim 1 or 2, in which the circuitry parameters of the further components have at least one of the following parameters:

- different temperatures to which the circuit is subjected,
- different quality of the further components,
- different dimensioning values of the further components.

**4.** Method according to one of Claims 1 to 3,
in which a stability analysis is carried out at the operating point for at least some of the parameter combinations.

**5.** Method according to Claim 4,
in which the transient response of the parameter combination is determined for at least some of the parameter combinations.

**6.** Apparatus for computer-aided determination of an oscillation-inception band of an electrical circuit which has at least one oscillator and further components which are connected to the oscillator, having a processor unit which is set up such that the following steps are in each case carried out for a parameter combination of the circuitry parameters using an iterative method and varying circuitry parameters of the further components:

- a stability analysis of the circuit is carried out for the respective parameter combination,
- if it is found for the parameter combination of the circuit that the parameter combination starts to oscillate, then that parameter combination is allocated a first value in a matrix in which all the investigated parameter combinations are stored, with the first value indicating that the parameter combination starts to oscillate,
- if it is found for the parameter combination of the circuit that the parameter combination does not start to oscillate, then that parameter combination is allocated a second value in the matrix, with the second value indicating that the parameter combination does not start to oscillate,
- the oscillation-inception band is obtained from the parameter combinations to which the first value in the matrix was allocated.

**7.** Apparatus according to Claim 6, in which the processor unit is set up such that the stability analysis is carried out using one of the following methods:

- determination of a hop bifurcation point for the respective entity,
- pole zero-point analysis,
- AC analysis (small signal analysis) using the Bode criterion or the Nyquist criterion,
- transient analysis.

**8.** Apparatus according to Claims 6 or 7, in which the processor unit is set up such that the circuitry parameters of the further components have at least one of the following parameters:

- different temperatures to which the circuit is subjected,
- different quality of the further components,
- different dimensioning values of the further components.

**9.** Apparatus according to one of Claims 6 to 8,
in which the processor unit is set up such that a stability analysis is carried out at the operating point for at least some of the parameter combinations.

**10.** Apparatus according to Claim 9,
in which the processor unit is set up such that the transient response of the parameter combination is determined for at least some of the parameter combinations.

**Revendications**

**1.** Procédé pour déterminer de manière assistée par ordinateur une zone d'amorçage d'oscillations d'un circuit électrique qui comporte au moins un oscillateur et des composants supplémentaires qui sont reliés à l'oscillateur,
dans lequel on effectue, dans un procédé itératif, en faisant varier des paramètres de connexion des composants supplémentaires chaque fois pour une combinaison des paramètres de connexion, les étapes suivantes :

- on effectue pour la combinaison de paramètres associés une analyse de stabilité du circuit,
- on détermine pour la combinaison de paramètres du circuit que la combinaison de paramètres amorce des oscillations, on associe ainsi dans une matrice dans laquelle sont mémorisées toutes les combinaisons de paramètres examinées une première valeur à la combinaison de paramètres, la première valeur indiquant que la combinaison de paramètres amorce des oscillations,

- on détermine pour la combinaison de paramètres du circuit que la combinaison de paramètres n'amorce pas d'oscillation, on associe ainsi dans la matrice une deuxième valeur à la combinaison de paramètres, la deuxième valeur indiquant que la combinaison de paramètres n'amorce pas d'oscillation,
- dans lequel on obtient la zone d'amorçage d'oscillations à partir des combinaisons de paramètres auxquelles la première valeur a été associée dans la matrice.

2. Procédé suivant la revendication 1,
   dans lequel on effectue l'analyse de stabilité suivant l'un des procédés suivants :

   - détermination d'un point de bifurcation Hopf pour l'instance associée,
   - analyse de zéro polaire,
   - analyse AC (analyse de petit signal) en utilisant le critère de Bode ou le critère de Nyquist,
   - analyse de transitoires.

3. Procédé suivant la revendication 1 ou 2,
   dans lequel les paramètres de connexion des composants supplémentaires comportent au moins l'un des paramètres suivants :

   - températures différentes auxquelles le circuit est soumis,
   - qualités différentes des composants supplémentaires,
   - valeurs de dimensionnement différentes des composants supplémentaires.

4. Procédé suivant l'une des revendications 1 à 3, dans lequel on effectue une analyse de stabilité au point de fonctionnement au moins pour une partie des combinaisons de paramètres.

5. Procédé suivant la revendication 4, dans lequel on effectue une détermination du régime transitoire de la combinaison de paramètres au moins pour une partie des combinaisons de paramètres.

6. Dispositif pour déterminer de manière assistée. par ordinateur une zone d'amorçage d'oscillations d'un circuit électrique qui comporte au moins un oscillateur et des composants supplémentaires qui sont reliés à l'oscillateur,
   comportant une unité de processeur qui est constituée de telle manière qu'il est effectué, dans un procédé itératif, en faisant varier des paramètres de connexion des composants supplémentaires chaque fois pour une combinaison des paramètres de connexion, les étapes suivantes :

   - il est effectué une analyse de stabilité du circuit pour la combinaison de paramètres associés,
   - s'il est déterminé pour la combinaison de paramètres de circuit que la combinaison de paramètres amorce des oscillations, il est associé dans une matrice dans laquelle sont mémorisées toutes les combinaisons de paramètres examinées une première valeur à la combinaison de paramètres, la première valeur indiquant que la combinaison de paramètres amorce des oscillations,
   - s'il est déterminé pour la combinaison de paramètres du circuit que la combinaison de paramètres n'amorce pas d'oscillation, il est associé dans la matrice une deuxième valeur à la combinaison de paramètres, la deuxième valeur indiquant que la combinaison de paramètres n'amorce pas d'oscillation,
   - la zone d'amorçage d'oscillations est obtenue à partir des combinaisons de paramètres auxquelles la première valeur a été associée dans la matrice.

7. Dispositif suivant la revendication 6,
   dans lequel l'unité de processeur est constituée de telle manière que l'analyse de stabilité est effectuée suivant l'un des procédés suivants :

   - détermination d'un point de bifurcation Hopf pour l'instance associée,
   - analyse de zéro polaire,
   - analyse AC (analyse de petit signal) en utilisant le critère de Bode ou le critère de Nyquist,
   - analyse de transitoires.

8. Dispositif suivant la revendication 6 ou 7,
   dans lequel l'unité de processeur est constituée de telle manière que les paramètres de connexion des composants supplémentaires comportent au moins l'un des paramètres suivants:

- températures différentes auxquelles le circuit est soumis,
- qualités différentes des composants supplémentaires,
- valeurs de dimensionnement différentes des composants supplémentaires.

9. Dispositif suivant l'une des revendications 6 à 8, dans lequel l'unité de processeur est constituée de telle manière qu'il est effectué une analyse de stabilisation au point de fonctionnement au moins pour une partie des combinaisons de paramètres.

10. Dispositif suivant la revendication 9, dans lequel l'unité de processeur est constituée de telle manière qu'il est effectué une détermination du régime transitoire de la combinaison de paramètres au moins pour une partie des combinaisons de paramètres.

## FIG 1

| CX1(pF) | 0,0 | 1,0 | 2,2 | 4,7 | 10,0 | 22,0 | 47,0 | 68,0 | 100,0 | 220,0 | 470,0 |
|---------|-----|-----|-----|-----|------|------|------|------|-------|-------|-------|
| CX2(pF) | 104 |     |     |     | 103  |      |      |      |       |       |       |
| 0,0     |     |     |     |     |      |      |      |      |       |       |       |
| 1,0     |     |     |     |     |      |      |      |      |       |       |       |
| 2,2     |     |     |     |     | 105  |      |      |      |       |       |       |
| 4,7     |     |     |     |     |      |      |      |      |       |       |       |
| 10,0    |     |     |     |     |      |      |      |      |       |       |       |
| 22,0    |     |     |     |     |      |      |      |      |       |       |       |
| 47,0    |     |     |     |     |      |      |      | 108  |       |       |       |
| 68,0    |     | 102 |     |     |      |      |      | 106  |       |       |       |
| 100,0   |     |     |     |     |      |      | 107  |      |       |       |       |
| 220,0   |     |     |     |     |      |      |      |      |       |       |       |

101

////// Anschwingen erfolgreich

\\\\\\ Anschwingen erfolglos

▨▨▨ optimaler Bereich

100

EP 1 034 494 B1

FIG 4

FIG 2

FIG 3

EP 1 034 494 B1